# EUROPEAN PATENT SPECIFICATION

(11) **EP 4 016 647 B1**
(45) Date of publication and mention of the grant of the patent: **07.02.2024**
(21) Application number: 20214245.1
(22) Date of filing: 15.12.2020
(51) Int. Cl.: H01L 29/861, H01L 21/329, H01L 29/32, H01L 21/268

(54) **STRUCTURE FOR A SEMICONDUCTOR DEVICE AND METHOD FOR PRODUCING A STRUCTURE FOR A SEMICONDUCTOR DEVICE**
STRUKTUR FÜR EIN HALBLEITERBAUELEMENT UND VERFAHREN ZUR HERSTELLUNG EINER STRUKTUR FÜR EIN HALBLEITERBAUELEMENT
STRUCTURE POUR DISPOSITIF À SEMI-CONDUCTEUR ET PROCÉDÉ DE FABRICATION D'UNE STRUCTURE POUR UN DISPOSITIF À SEMI-CONDUCTEUR

(43) Date of publication of application: 22.06.2022
(73) Proprietor: Hitachi Energy Ltd, 8050 Zürich (CH)
(72) Inventor: Buitrago, Elizabeth, 5210 Windisch (CH); Papadopoulos, Charalampos, 5600 Lenzburg (CH); Corvasce, Chiara, 8962 Bergdietikon (CH); Rahimo, Munaf, 4716 Gänsbrunnen (CH)
(74) Representative: Epping - Hermann - Fischer

(56) References cited:
- US-A1- 2015 303 268
- US-A1- 2019 058 065
- SUHEI HARA ET AL: "A defect behavior in boron shallow junction formation of Si under low-temperature pre-anneal and non-melt-laser anneal", JUNCTION TECHNOLOGY (IWJT), 2010 INTERNATIONAL WORKSHOP ON, IEEE, PISCATAWAY, NJ, USA, 10 May 2010 (2010-05-10), pages 1-4, XP031682739, ISBN: 978-1-4244-5866-0

## Description

The disclosure relates to a structure for a semiconductor device (not claimed) and a method for producing a structure for a semiconductor device (claimed). Semiconductor devices are used in many technical areas.

Design optimization of such power semiconductor devices is often coupled with an optimization of an injection efficiency of at least one of an anode layer and a cathode layer.

Control of the injection efficiency is generally achieved by varying dopant doses.

Document US 2019/058065 A1 concerns a power Diode and a method of manufacturing a power diode. The power diode comprises, above a drift region of a first conductivity type, an anode field stop zone, an anode damage zone and an anode contact zone, of a second conductivity type and stacked in this sequence. The anode contact and damage zones are formed by a single ion implantation processing step followed by a low-temperature annealing processing step. Document US 2015/303268 A1 concerns a diode and a power conversion device.

Embodiments of the disclosure address in whole or in part the above shortcomings by a structure for a semiconductor device, which has an improved injection efficiency and by a method for producing such a structure.

The exemplary embodiment of the disclosure addresses the above shortcomings by the subject-matter of the independent claim.

Further embodiments are evident from the dependent claims and the following description. In particular, the present invention is defined by the attached set of claims.

The first aspect of the disclosure relates to a structure for a semiconductor device. The semiconductor device is, for example, a diode, an insulated gate bipolar transistor, abbreviated as IGBT or a metal-oxide-semiconductor field-effect transistor, abbreviated as MOSFET. Exemplarily, the semiconductor device is, for example, a Non-Punch-Through (NPT) device or a Soft-Punch-Through (SPT) device.

The semiconductor device is, for example, a power semiconductor device. The term "power" here and in the following, for example, refers to power semiconductor devices adapted for processing voltages and currents of more than 100 V and/or more than 10 A, exemplary voltages up to 1200 V and currents of several hundred amperes.

A structure which can be manufactured according to the invention comprises a contact layer comprising first dopants of a first conductivity type. The contact layer comprises or consists, for example, of a semiconductor material. For example, the contact layer comprises first dopants, such as p-type dopants. In this case the first conductivity type is a p-type conductivity. Alternatively, the contact layer comprises first dopants being n-type dopants such that the first conductivity type is an n-type conductivity. Exemplarily, the contact layer is externally contactable in an electrical conductive manner.

The contact layer has, for example, a main extension plane. For example, lateral directions are aligned parallel to the main extension plane and a vertical direction is aligned perpendicular to the main extension plane.

The structure comprises a base layer of a second conductivity type different than the first conductivity type. The base layer comprises or consists of a semiconductor material, which is, for example, the same material than the semiconductor material of the contact layer. The second conductivity type is, for example, an n-type conductivity. Alternatively, the second conductivity type is a p-type conductivity. Exemplarily the second conductivity type is different from the first conductivity type. This is to say that if the contact layer is of a p-conductivity type, the base layer is of an n-conductivity type and vice versa.

For example, the base layer does not comprise the first dopants. Exemplarily, the base layer is completely free of the first dopants.

The structure comprises a defect layer comprising first dopants of the first conductivity type, wherein a concentration of the first dopants being activated in the contact layer is higher than a concentration of the first dopants being activated in the defect layer.

The defect layer comprises or consists of a semiconductor material exemplarily being the same semiconductor material than the semiconductor material of the contact layer. For example, the concentration of the first dopants being activated decreases from the contact layer to the defect layer continuously.

The first dopants exemplarily contribute to electronic properties of the contact layer and the defect layer, such as the conductivity. Further, due to the contribution of the first dopants to the electronic properties, for example, also an injection efficiency is dependent on the first dopants. Thus, the injection efficiency can be pre-set depending on the first dopants.

At least some of the first dopants can be located exemplarily at interstitial lattice sites of at least one of the contact layer and the defect layer. Further, at least some of the first dopants can be located exemplarily at substitutional lattice sites of at least one of the contact layer and the defect layer.

The first dopants are introduced exemplarily by an implantation process. The implantation process destroys, for example, a long range order of a crystal lattice of at least one of the contact layer and the defect layer. Thus, the injection increases an amorphousness of the crystal lattice of at least one of the contact layer and the defect layer.

If at least some of the first dopants are located at interstitial lattice sites, sites in the crystal lattice of at least one of the contact layer and the defect layer are occupied by the first dopants, at which there is usually not an atom. The amorphousness of at least one of the contact layer and the defect layer increases, for example, if the number of first dopants located at interstitial lattice sites increases and vice versa.

If at least some of the first dopants are located at substitutional lattice sides, sites in the crystal lattice of at least one of the contact layer and the defect layer are occupied by the first dopants, at which there is usually an atom. Thus, the first dopants are incorporated at a regular site in the crystal structure. For example, the amorphousness of at least one of the contact layer and the defect layer decreases, for example, if the number of first dopants located at substitutional lattice sites increases and vice versa.

For example, if the amorphousness of at least one of the contact layer and the defect layer increases, the injection efficiency of at least one of the contact layer and the defect layer decreases and vice versa.

For example, the first dopants being activated are located exemplarily at substitutional lattice sites. Furthermore, the first dopants being not activated are located exemplarily at interstitial lattice sites, for example.

The concentration of the first dopants being activated in the contact layer is, for example, at least 100, exemplarily 500, higher than the concentration of the first dopants being activated in the defect layer.

Exemplarily, the concentration of the first dopants being activated in the contact layer is at least 1·10¹⁸ cm⁻³. The concentration of the first dopants being activated within the defect layer is, for example, at most 1·10¹⁷ cm⁻³.

In summary, such a structure for a semiconductor device can provide, inter alia, the following advantage. Exemplarily, the injection efficiency of the structure can be preset by the concentration of the first dopants being activated in the contact layer and the defect layer. With such a combination of the contact layer and the defect layer, the injection efficiency can be pre-set according to the needs of the semiconductor device.

According to the invention, the defect layer is provided between the contact layer and the base layer at least in regions. For example, the base layer, the defect layer and the contact layer are stacked above one another in vertical direction in the order indicated. For example, the defect layer is in direct contact to the base layer.

Exemplarily, the defect layer is provided completely between the contact layer and the base layer. In this case, the defect layer covers a main surface of the contact layer facing the defect layer completely.

Alternatively, the defect layer does not cover the main surface of the contact layer completely. In this case, the defect layer has a cross sectional shape in lateral directions being circular, elliptical or polygonal. Furthermore, the defect layer can be located solely in regions of grid points of a grid, for example. The defect layer has at the grid points the cross sectional shape in lateral directions being circular, elliptical or polygonal.

For example, the contact layer and the defect layer have a difference of the concentrations of the first dopants being activated. Exemplarily, the defect layer extends up to a boundary, wherein the boundary extends in lateral directions and is located between the contact layer and the defect layer in vertical direction. For example, the concentration of the first dopants being activated in the defect layer rises up to 500 of the difference at the boundary. Analogously, the concentration of the first dopants being activated in the contact layer drops down to 500 of the difference at the boundary.

According to at least one embodiment of the structure, a defect concentration in the contact layer is less than a defect concentration in the defect layer. For example, at least some of the first dopants form crystallographic defects in at least one of the contact layer and the defect layer. Crystallographic defects are exemplarily interruptions of the crystal lattice of at least one of the contact layer and the defect layer such as atoms located at interstitial sites of the crystal lattice. Furthermore, crystallographic defects can be formed from vacancy defects. A vacancy defect is exemplarily a vacant lattice site in the crystal lattice of at least one of the contact layer and the defect layer. For example, the defect concentration accounts all the crystallographic defects.

Furthermore, the injection efficiency of at least one of the contact layer and the defect layer is dependent to the defect concentration. If the defect concentration is increased, for example, the injection efficiency decreases and vice versa.

The defect concentration in the defect layer is, for example, at least 100, exemplarily 500, higher than the defect concentration of the first dopants being activated in the defect layer.

According to at least one embodiment of the structure, a buffer layer of the second conductivity type is provided between the contact layer and the defect layer and the base layer. The buffer layer comprises or consists of a semiconductor material. In this embodiment, the base layer is in direct contact to the buffer layer.

For example, the buffer layer is higher doped. Exemplary, the base layer has a homogeneous doping concentration and the buffer layer has a higher doping concentration than the homogeneous doping concentration of the base layer.

For example, the base layer, the buffer layer, the defect layer and the contact layer are stacked above one another in vertical direction in the order indicated. In this case, the buffer layer is in direct contact to the defect layer.

Alternatively, the base layer, the buffer layer, the contact layer and the defect layer are stacked above one another in vertical direction in the order indicated. In this case, the buffer layer is in direct contact to the contact layer.

According to at least one embodiment of the structure, the contact layer and the defect layer are at least one of an anode layer and a cathode layer for a semiconductor device.

For example, the at least one of an anode layer and a cathode layer is configured to be contacted with a metallization. Exemplarily, at least one of an anode layer and a cathode layer is freely accessible from an outside.

A second aspect of the disclosure relates to a semiconductor device. The semiconductor device comprises a structure disclosed herein before. Thus, all features disclosed in connection with the structure are also disclosed in connection with the semiconductor device and vice versa.

A third aspect of the disclosure relates to a method for producing a structure for a semiconductor device, as defined in claim 1. The method produces a structure for a semiconductor device described herein above. All features disclosed in connection with the structure are therefore also disclosed in connection with the method and vice versa.

According to the embodiment of the second aspect of the method, a base layer and a semiconductor film being arranged on the base layer are provided. Exemplarily, the semiconductor film is grown epitaxially on the base layer.

According to the invention, first dopants are introduced to the semiconductor film. For example, the first dopants are injected in the semiconductor film. Exemplarily, first dopants are introduced to the semiconductor film up to a certain depth. For example, the depth is smaller than a thickness of the semiconductor film in vertical direction. Alternatively, the depth equals the thickness of the semiconductor film in vertical direction.

According to the invention, the semiconductor film is heated at least in regions such that a contact layer and a defect layer are generated at least in regions. Exemplarily, due to the heating, at least some of the first dopants can move from interstitial lattice sites to substitutional lattice sites.

The method steps are carried out in the following order: providing a base layer and a semiconductor film being arranged on the base layer, introducing first dopants to the semiconductor film, heating the semiconductor film at least in regions.

The contact layer and the defect layer are of a first conductivity type and the base layer is of a second conductivity type.

A concentration of the first dopants of the first contact layer being activated is higher than a concentration of the first dopants of the defect layer being activated.

According to at least one embodiment of the method, the first dopants are introduced to the semiconductor film with a dose of at least 1·10¹⁴cm⁻². Exemplarily, the first dopants are introduced to the semiconductor film with a dose of at least 1·10¹⁵cm⁻². For example, first dopants comprise or consists of at least one of Boron and Phosphorous.

According to at least one embodiment of the method, a first heating step is applied to the semiconductor film after the introduction of the first dopants. For example, the semiconductor film is heated to at least 900 °C in the first heating step. Exemplarily, within this step the whole semiconductor film with the first dopants is annealed such that at least some of the first dopants move from interstitial to substitutional lattice sides in the semiconductor film.

Within this step, an amorphousness of the semiconductor film is exemplarily decreased as a whole, for example.

According to the invention, further first dopants are introduced to the semiconductor film after the first heating step. Exemplary, the further first dopants are the same dopants than the first dopants. Alternatively, the further first dopants comprise a different material than the first dopants.

The further first dopants are introduced to the semiconductor film, e.g., up to a depth being less than the thickness of the semiconductor film in vertical direction. Alternatively, the further first dopants are introduced to the semiconductor film, e.g., up to a depth being equal to the thickness of the semiconductor film in vertical direction.

If the first dopants are introduced in the semiconductor film up to the depth being smaller than the thickness of the semiconductor film in vertical direction, the further first dopants are introduced to the semiconductor film up to a depth being larger than the depth of the first dopants in vertical direction.

In the case the further first dopants are introduced in the semiconductor film up to the depth being smaller than depth of the first dopants, a region of the semiconductor film closer to the outer surface comprises the further first dopants and a region of the semiconductor film closer to the base layer is free of the further first dopants. Exemplarily, an amorphousness of the semiconductor film is increased in the region closer to the outer surface.

In the case the further first dopants are introduced in the semiconductor film up to the depth being larger than the depth of the first dopants, a region of the semiconductor film closer to the outer surface comprises the further first dopants and the first dopants being activated and a region of the semiconductor film closer to the base layer comprises the further first dopants. Exemplarily, an amorphousness of the semiconductor film is increased in the region closer to the base layer.

According to at least one embodiment of the method, the further first dopants are introduced to the semiconductor film with a dose of at most 1·10¹⁴cm⁻². The further first dopants are introduced to the semiconductor film with an applied energy of at most 100 keV. For example, the further first dopants comprise or consists of at least one of Boron and Phosphorous.

According to the invention, a second heating step is applied to the semiconductor film such that the defect layer is generated. For example, the semiconductor film is heated in the second heating step to at most 500 °C. Exemplarily, at least some of the further first dopants move from interstitial to substitutional lattice sides in the semiconductor film due to the second heating step. In this case, the moving is not as efficient as compared to the first heating step. Thus, comparatively less further first dopants move from interstitial to substitutional lattice sides.

Exemplarily, the region of the semiconductor film closer to the outer surface comprising the further first dopants forms the defect region and the region of the semiconductor film closer to the base layer being free of the further first dopants forms the contact layer.

Alternatively, the region of the semiconductor film closer to the base layer comprising the further first dopants forms the defect region and the region of the semiconductor film closer to the base layer comprising the first dopants and the further first dopants forms the contact layer.

According to at least one embodiment of the method, the first heating step is a laser process or a furnace process.

According to at least one embodiment of the method, the second heating step is a sintering process.

For example, a metallization is provided on the outer surface of the semiconductor film. Exemplarily, the metallization comprises or consists of a metal. For example this metallization can be provided on the outer surface of the semiconductor film by the sintering process.

According to the invention, a temperature of the first heating step is higher than a temperature of the second heating step.

According to at least one embodiment of the method, a buffer layer is provided on the base layer. This is to say that a buffer layer is provided between the base layer and the contact layer.

The subject-matter of the disclosure will be explained in more detail in the following with reference to exemplary embodiments which are illustrated in the attached drawings.
Figure 1 schematically shows a cross-sectional view of a structure according to prior art and an embodiment which can be manufactured according to the invention;
Figures 2 and 3 each exemplarily shows spreading resistance profiles of different structures according to different embodiments;
Figure 4 exemplarily shows a technology curve of different structures according to different embodiments;
Figure 5 exemplarily shows spreading resistance profiles of different structures according to different embodiments;
Figure 6 exemplarily shows a technology curve of different structures according to different embodiments;
Figure 7 exemplarily shows turn off wave forms of structures of a semiconductor device;
Figure 8 exemplarily shows nominal on-state measurements of structures of a semiconductor device
Figures 9 and 10 each exemplarily shows spreading resistance profiles of different structures according to different embodiments;
Figure 11 schematically shows a flow diagram of a method for producing a structure for a semiconductor device according to an embodiment.

The reference symbols used in the drawings and their meanings are listed in summary form in the list of reference symbols. In principle, identical parts are provided with the same reference symbols in the figures.

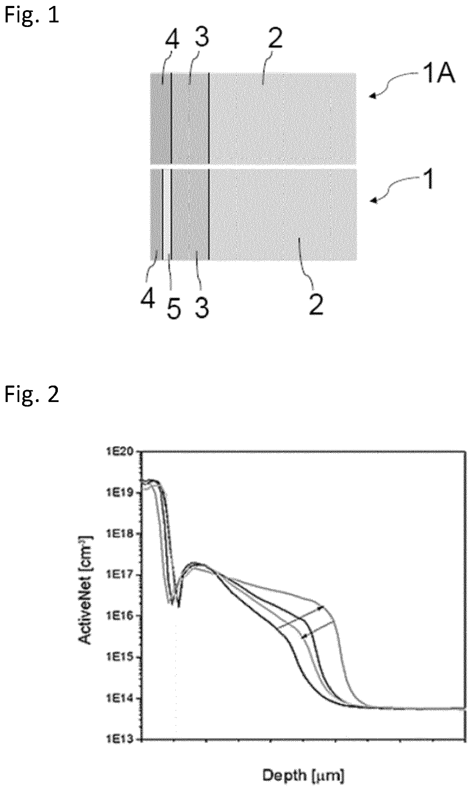

The structure shown on the top of Figure 1 schematically shows a structure 1A of a semiconductor device according to the prior art.

The structure shown on the bottom of Figure 1 shows a structure 1 of a semiconductor device according to an embodiment.

The structure 1 of Figure 1 comprises a contact layer 4 comprising first dopants of a first conductivity type and a defect layer 5 comprising first dopants of the first conductivity type. The contact layer 4 and the defect layer 5 are arranged on a buffer layer 3 and a base layer 2.

The contact layer 4, the defect layer 5, the buffer layer 3 and a base layer 2 are stacked above one another and are in direct contact to one another. Furthermore, a concentration of the first dopants being activated in the contact layer 4 is higher than a concentration of the first dopants being activated in the defect layer 5.

For example, a width of the contact layer 4 is at most 5 um. In this embodiment, a width of the defect layer 5 is smaller than the width of the contact layer 4.

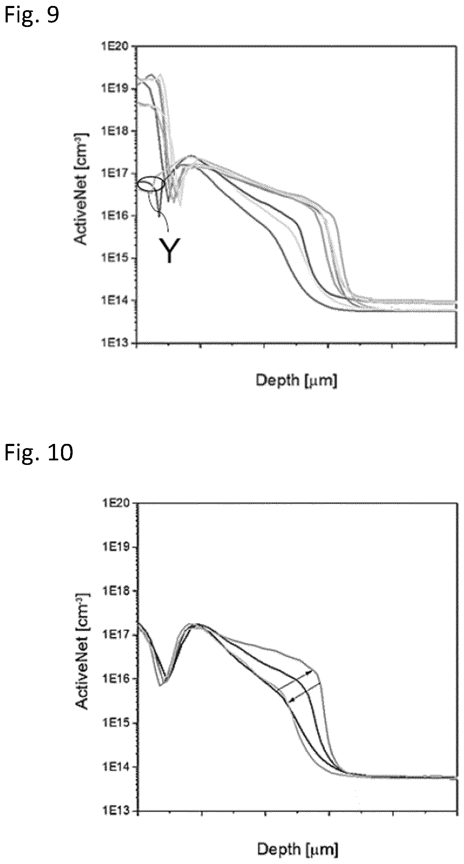

In Figure 2, spreading resistance profiles (SRPs) of four different structures 1 are shown. A SRP represents a measurement of a resistivity of a semiconducting device with a structure 1, as a function of a position. The measured resistivity is proportional to a carrier density being activated, i.e. the number of electrically active electrons or holes in a given volume. Thus, the SRP is proportional to a concentration of the first dopants being activated depicted by "ActiveNet" in cm⁻³. The range of the x-Axis for Figures 2, 3 and 5 is from 0 um to 3 um and for Figures 9 and 10 from 0 um to 2.5 um.

A contact layer 4 and a defect layer 5 of the structures 1 are used as an anode layer in a semiconductor device. The first dopants are in this case Boron and Phosphorous. Furthermore, the four different structures 1 have all the same buffer layers 3.

The buffer layers 3 are of a second conductivity type and, for example, are generated by ion implantation of second dopants. The second dopants of the buffer layers 3 are activated, for example, by laser process.

The contact layer 4 and the defect layer 5 are generated by initially incorporating first dopants to a semiconductor film. The dose of the first dopants is the same for the four structures 1.

In an example not covered by the claims, the first dopants in the contact layer 4 and the defect layer 5 of the structures 1 are activated by a laser process, being an incomplete laser annealing process, using four different laser energies from 1.1 Joules to 1.4 Joules - and thereby generating the contact layer 4 and the defect layer 5 having a combined injection efficiency being different for all the four structures 1.

The SRP having the lowest concentration at 1 um corresponds to a laser energy of 1.1 J. The SRP having the second lowest concentration at 1 µm, i.e. at the fourth tick of the x-axis - corresponds to a laser energy of 1.4 J, the SRP having the third lowest concentration at 1 um corresponds to a laser energy of 1.2 J and the SRP having the highest concentration at 1 um corresponds to a laser energy of 1.3 J.

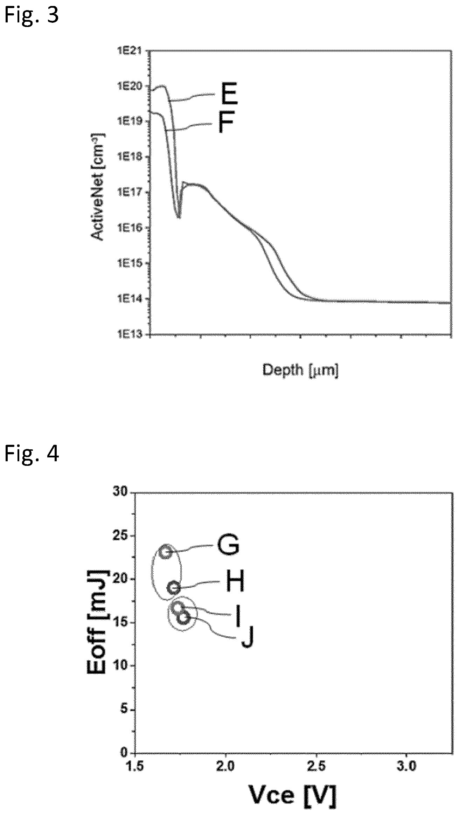

Figure 3 shows the SRPs of two structures 1. The structure 1 in connection with the SRP "E" is produced by only one heating step (not claimed). However, the contact layer 4 and the defect layer 5 of the structure 1 in connection with the SRP "F" are generated by incorporating first dopants to a semiconductor film followed by a first heating step and an incorporation of further first dopants to the semiconductor film followed by a second heating step.

Figure 4 shows a turn-off loss Eoff in mJ depending to a collector-emitter voltage Vce in V for different structures 1. Such a representation is also called "technology curve".

First dopants are incorporated in the semiconductor film of the structures 1 of semiconductor devices corresponding to "G" and "I" with a dose of 1·10¹⁵ cm⁻². Further, first dopants are incorporated in the semiconductor film of the structures 1 of devices corresponding to "H" and "J" with a dose of 5·10¹⁵ cm⁻². Subsequently, the semiconductor film of the structures 1 corresponding to "G" and "H" are heated by an incomplete annealing process (not claimed) with an energy of 1.3 J - thereby generating the contact layer 4 and the defect layer 5. In addition, the semiconductor film of the structures 1 corresponding to "I" and "J" are heated subsequently by an incomplete annealing process (not claimed) with an energy of 1.1 J - thereby generating the contact layer 4 and the defect layer 5.

By having the same laser process energies, a structure 1 of a semiconductor device treated with a higher dose has a higher on-state due to the incomplete annealing of defects during the laser annealing process. Thus, the injection efficiency decreases, that means the on-state increases, with an increase in the dose.

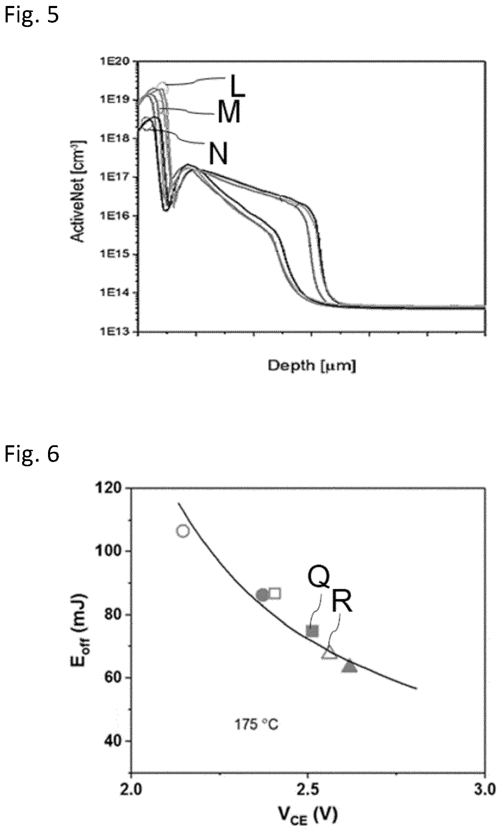

Figure 5 shows the SRPs of six structures 1. The two structures 1 corresponding to "L" are not provided with a further incorporation of further first dopants as claimed. The two structures 1 corresponding to "M" are provided with a further incorporation of further first dopants with a dose of 1·10¹³ cm⁻² using an energy of 25 keV. The two structures 1 corresponding to "N" are provided with a further incorporation of further first dopants with a dose of 1·10¹⁴ cm⁻² using an energy of 25 keV.

Furthermore, the three SRPs having the three concentrations at 1 um each correspond to a laser energy of 1.6 J. The three SRPs having the three highest concentrations at 1 µm each correspond to a laser energy of 1.4 J.

Figure 6 shows the turn-off loss Eoff in mJ depending to the collector-emitter voltage Vce in V for different structures 1.

The structures 1 of different semiconductor devices depicted with a symbol being not filled, i.e. the device marked with "R", are annealed with a laser process having an energy of 1.6 J. The structures 1 of different devices depicted with a symbol being filled, i.e. the device marked with "Q", are annealed with a laser process having an energy of 1.4 J. The devices depicted by circles are produced with one injection step and one incomplete annealing step (not claimed).

The devices depicted by squares and triangles are produced with two injection steps and two annealing steps. The defect layers 5 of the devices depicted by squares are produced with a lower dose of further first dopants than the defect layers 5 of the devices depicted by triangles.

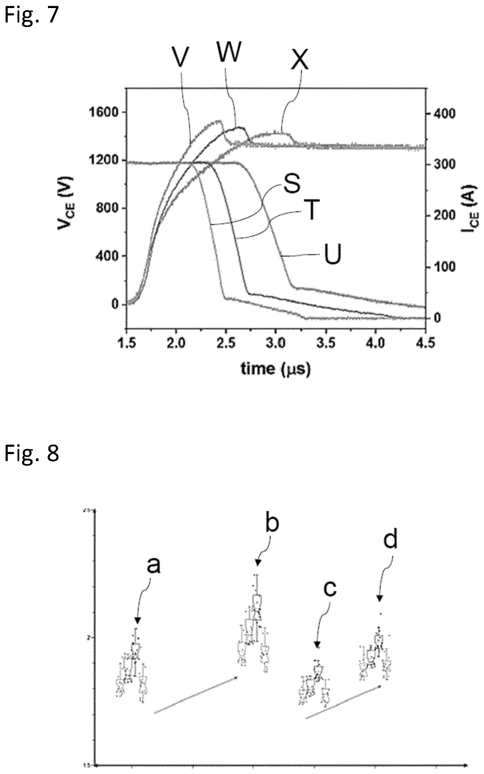

Figure 7 schematically shows turn off waveforms measured at reverse-bias safe operating area (RBSOA) conditions, which are applying a maximum voltage of 1300 V and 300 A at 175 °C for three different 1700 V semiconductor devices, each provided with a structure 1 according to an embodiment.

The device depicted by "S" and "V" are produced with one injection step and one incomplete annealing step (not claimed). The defect layer 5 of the device depicted by "T" and "W" as well as "U" and "X" are produced with two injection steps and two annealing steps. For the device depicted by "T" and "W", the further first dopants are introduced in the semiconductor film with a dose of 1·10¹²cm⁻². For the device depicted by "U" and "X", the further first dopants are introduced in the semiconductor film with a dose of 5·10¹²cm⁻². The further first dopants are formed of, e.g., Boron.

The nominal on-state measurements of structures 1 of different semiconductor devices are shown in Figure 8.

The measuring point cluster depicted by "a" corresponds to structures 1 of four semiconductor devices, which are produced with one injection step and one incomplete annealing step. The first dopants are incorporated with a dose from at least 10¹³ cm⁻² and at most 5 10¹⁶ cm⁻². The structures 1 are annealed with an incomplete laser process (not claimed) having energies of 1.5 J for the device on the first position from the left, 2.0 J for the device on the second position from the left, 2.5 J for the device on the third position from the left and 3.0 J for the device on the fourth position from the left.

The measuring point cluster depicted by "b" corresponds to structures 1 of four semiconductor devices, which are produced with two injection steps and two annealing steps. Further first dopants are incorporated, e.g., Boron, in the semiconductor film in order to produce the defect layer 5, in comparison to the devices depicted by "a".

The measuring point cluster depicted by "c" corresponds to structures 1 of four semiconductor devices, which are produced similarly to the devices depicted by "a". In comparison, first dopants are incorporated in the semiconductor film in order to produce the defect layer 5 having a dose being higher than a dose of the first dopants in connection with the devices depicted by "a".

The measuring point cluster depicted by "d" corresponds to structures 1 of four semiconductor devices, which are produced similarly to the devices depicted by "b". In comparison, first dopants are incorporated with a first incorporation step in the semiconductor film in order to produce the defect layer 5 having a dose being higher than a dose of the first dopants in connection with the devices depicted by "b".

Figure 9 shows the SRPs of seven structures 1 of different semiconductor devices. The contact layers 4 and the defect layers 5 of the devices are produced with different annealing energies of the laser process. In comparison to Figure 5, the doses for incorporating the first dopants and the further first are higher. In a depth range from 0.0 um to 0.5 um, the region indicated by "Y" corresponds to a SRP of a device, which is produced having a higher dose of further first dopants than the device depicted by "N" in Figure 5.

Figure 10 shows the SRPs of four structures 1 of different semiconductor devices, wherein the dose of the first dopants is greater than 10¹⁵ cm⁻¹ and the dose of the further first dopants is greater than 10¹⁵ cm⁻².

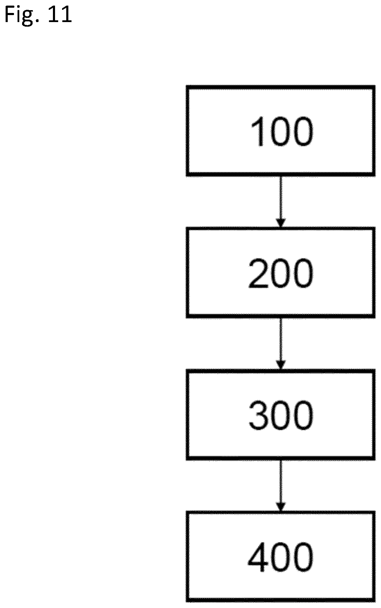

According to Figure 11, initially a base layer 2 and a semiconductor film being arranged on the base layer 2 are provided 100. Subsequently first dopants are introduced 200 to the semiconductor film. In a next step, the semiconductor film is heated 300 at least in regions such that a contact layer 4 and a defect layer 5 is generated 400 at least in regions. Here, the contact layer 4 and the defect layer 5 are of a first conductivity type and the base layer 2 is of a second conductivity type. Further, a concentration of the first dopants of the contact layer 4 being activated is higher than a concentration of the first dopants of the defect layer 5 being activated.

### Reference signs list

- 1: structure
- 1A: structure according to prior art
- 2: base layer
- 3: buffer layer
- 4: contact layer
- 5: defect layer

- a-d: measuring point cluster

- E-F: SRP
- G-J: structures corresponding to measurement point
- L-P: SRPs
- Q, R: structures corresponding to measurement point
- S-X: structures corresponding to measurement point
- Y: region of SRP

## Claims

1. A method for producing a structure (1) for a semiconductor device comprising:
- providing a base layer (2) and a semiconductor film being arranged on the base layer (2),
- introducing first dopants to the semiconductor film,
- heating the semiconductor film at least in regions such that a contact layer (4) and a defect layer (5) are generated at least in regions, wherein
- the contact layer (4) and the defect layer (5) are of a first conductivity type and the base layer (2) is of a second conductivity type,
- a concentration of the first dopants of the contact layer (4) being activated is higher than a concentration of the first dopants of the defect layer (5) being activated, wherein the heating comprises at least two heating steps wherein
- after the introduction of the first dopants, a first heating step is applied to the semiconductor film,
- after the first heating step, further first dopants are introduced to the semiconductor film,
- after the introduction of the further first dopants, a second heating step is applied to the semiconductor film such that the defect layer (5) is generated,
- a temperature of the first heating step is higher than a temperature of the second heating step so that in the second heating step comparatively less further first dopants move from interstitial to substitutional lattice sides, and
- the defect layer (5) is provided between the contact layer (4) and the base layer (2) at least in regions.

2. The method according to claim 1, wherein the further first dopants are introduced to the semiconductor film with a dose of at most 1·10¹⁴cm⁻².

3. The method according to any one of claims 1 to 2, wherein
- the first heating step is a laser process or a furnace process, and
- the second heating step is a sintering process.

4. The method according to one of claims 1 to 3, wherein a buffer layer (3) is provided on the base layer (2).

## Patentansprüche

1. Verfahren zur Herstellung einer Struktur (1) für eine Halbleitervorrichtung, umfassend:
- Bereitstellen einer Basisschicht (2) und einer Halbleiter-Dünnschicht, die auf der Basisschicht (2) angeordnet ist,
- Einführen von ersten Dotierstoffen in die Halbleiter-Dünnschicht,
- Erhitzen der Halbleiter-Dünnschicht wenigstens in Bereichen, so dass eine Kontaktschicht (4) und eine Defektschicht (5) wenigstens in Bereichen erzeugt werden, wobei
- die Kontaktschicht (4) und die Defektschicht (5) von einem ersten Leitfähigkeitstyp sind und die Basisschicht (2) von einem zweiten Leitfähigkeitstyp ist,
- eine Konzentration der aktivierten ersten Dotierstoffe der Kontaktschicht (4) höher ist als eine Konzentration der aktivierten ersten Dotierstoffe der Defektschicht (5), wobei das Erhitzen wenigstens zwei Heizschritte umfasst, wobei
- nach dem Einführen der ersten Dotierstoffe ein erster Heizschritt auf die Halbleiter-Dünnschicht angewendet wird,
- nach dem ersten Heizschritt weitere erste Dotierstoffe in die Halbleiter-Dünnschicht eingeführt werden,
- nach dem Einführen der weiteren ersten Dotierstoffe ein zweiter Heizschritt auf die Halbleiter-Dünnschicht angewendet wird, so dass die Defektschicht (5) erzeugt wird,
- eine Temperatur des ersten Heizschritts höher als eine Temperatur des zweiten Heizschritts ist, so dass sich bei dem zweiten Heizschritt vergleichsweise weniger weitere erste Dotierstoffe von Zwischengitter- zu Substitutionsgitterplätzen bewegen, und
- die Defektschicht (5) wenigstens in Bereichen zwischen der Kontaktschicht (4) und der Basisschicht (2) bereitgestellt wird.

2. Verfahren gemäß Anspruch 1, wobei die weiteren ersten Dotierstoffe mit einer Dosis von höchstens 1·10¹⁴cm⁻² in die Halbleiter-Dünnschicht eingeführt werden.

3. Verfahren gemäß einem der Ansprüche 1 bis 2, wobei
- der erste Heizschritt ein Laserverfahren oder ein Ofenverfahren ist und
- der zweite Heizschritt ein Sinterverfahren ist.

4. Verfahren gemäß einem der Ansprüche 1 bis 3, wobei eine Pufferschicht (3) auf der Basisschicht (2) bereitgestellt wird.

## Revendications

1. Procédé pour la production d'une structure (1) pour un dispositif semi-conducteur comprenant :
- la fourniture d'une couche de base (2) et d'un film semi-conducteur qui est agencé sur la couche de base (2),
- l'introduction de premiers dopants dans le film semi-conducteur,
- le chauffage du film semi-conducteur au moins dans des zones de sorte qu'une couche de contact (4) et qu'une couche de défauts (5) soient générées au moins dans des zones,
- la couche de contact (4) et la couche de défauts (5) étant d'un premier type de conductivité et la couche de base (2) étant d'un deuxième type de conductivité,
- une concentration des premiers dopants de la couche de contact (4) qui sont activés étant supérieure à une concentration des premiers dopants de la couche de défauts (5) qui sont activés, le chauffage comprenant au moins deux étape de chauffage,
- après l'introduction des premiers dopants, une première étape de chauffage étant appliquée au film semi-conducteur,
- après la première étape de chauffage, d'autres premiers dopants étant introduits dans le film semi-conducteur,
- après l'introduction des autres premiers dopants, une deuxième étape de chauffage étant appliquée au film semi-conducteur de sorte que la couche de défauts (5) soit générée,
- une température de la première étape de chauffage étant supérieure à une température de la deuxième étape de chauffage de sorte que dans la deuxième étape de chauffage comparativement moins d'autres premiers dopants se déplacent de côtés de réseau interstitiels à substitutionnels, et
- la couche de défauts (5) étant placée entre la couche de contact (4) et la couche de base (2) au moins dans des zones.

2. Procédé selon la revendication 1, les autres premiers dopants étant introduits dans le film semi-conducteur avec une dose d'au plus 1·10¹⁴cm⁻².

3. Procédé selon l'une quelconque des revendications 1 à 2,
- la première étape de chauffage étant un processus laser ou un processus dans un fourneau, et
- la deuxième étape de chauffage étant un processus de frittage.

4. Procédé selon l'une des revendications 1 à 3, une couche tampon (3) étant placée sur la couche de base (2).
